# EUROPEAN PATENT SPECIFICATION

(11) **EP 1 722 615 B1**
(45) Date of publication and mention of the grant of the patent: **26.11.2008**
(21) Application number: 06252457.4
(22) Date of filing: 10.05.2006
(51) Int. Cl.: H05K 3/28, H05K 5/00, H01L 23/053

(54) **A printed circuit board having protection means and a method of use thereof**
Leiterplatte mit Schutzmittel und Verfahren zu ihrer Anwendung
Carte à circuit imprimé ayant des moyens de protection et sa méthode d'utilisation

(30) Priority: 10.05.2005 GB 0509483
(43) Date of publication of application: 15.11.2006
(73) Proprietor: Pace Plc, Saltaire Shipley West Yorkshire BD18 3LF (GB)
(72) Inventor: Fuller, Colin ; c/o Pace Micro Technology Plc, Shipley, BD18 3LF (GB); Ford, Peter ; c/o Pace Micro Technology Plc, Shipley, BD18 3LF (GB)
(74) Representative: Tomkinson, Alexandra

(56) References cited:
- EP-A- 0 764 984
- EP-A- 0 778 617
- EP-A- 1 337 135
- GB-A- 1 206 656
- GB-A- 1 237 681
- JP-A- 7 221 429
- JP-A- 8 055 937
- JP-A- 57 170 542
- US-A- 5 436 083

## Description

This invention relates to protection means for a printed circuit board (PCB) and a method of use of protection means for a PCB.

PCB's typically include at least an upper and lower surface with one or more electrical components located on one or both surfaces thereof. The PCB is then located in an item of electrical apparatus in use. It is often a requirement that one or more of the electrical components on the PCB are required to be covered with a fluid, such as an adhesive, to maintain the component in a suitable position on the PCB in use and to protect the same from damage, environmental conditions, tampering and/or the like. An example of such a component is a flash memory device. However, it is difficult to ensure that the adhesive is applied around the component to a pre-determined thickness which is reproducible for each PCB in a manner which is cost effective and which is not time consuming. It is also difficult to ensure that the adhesive does not flow onto any other component on the PCB which is not required to be covered by the adhesive since this may cause damage to the other component or make the same unserviceable. This also typically results in wastage of adhesive which increases the cost of producing the PCB.

It is known to provide a plastic rim around an integrated circuit chip on a circuit board and to locate a soft gel medium within the rim and surrounding the chip, as disclosed in EP 0 778 617 A. A plate made of plastic or metal is attached to the top surface of the plastic rim in order to provide a cover for the package to allow the conduction of heat generated by the chip during use away from the chip. However, EP 0 778 617 A is not concerned with preventing tampering or unauthorised access to the chip.

It is an aim of the present invention to provide alternative protection means for use on PCBs.

It is a further aim of the present invention to provide an alternative method of protecting one or more components of a PCB.

According to a first aspect of the present invention there is provided a printed circuit board with protection means for protecting one or more components of the printed circuit board (PCB), said protection means including a sleeve member located on the PCB around at least one component of the PCB, said protection means further including cover means for covering a whole or substantial part of an opening of said sleeve member, characterised in that the cover means is formed from or includes mica.

Thus, the present invention differs from the prior art in that mica, having high heat resistance and insulating properties, is used rather than a heat conducting material or simply plastic having much lower heat resistant properties. This allows the present invention to effectively dissipate heat applied to the cover means on the PCB by third parties trying to access the one or more components covered by the protection means, thereby significantly increasing the security of the PCB and/or covered components and preventing tampering therewith. The prior art devices are concerned only with conducting heat generated by the component during use away from the component to allow the device.

The sleeve member acts to limit the spread of a product or fluid located within a cavity defined by the interior walls of the sleeve member. The cover means acts to prevent or limit access to the interior of the sleeve member and to the component surrounded by the sleeve member.

Preferably the sleeve member is of such dimensions so as to allow a fluid to be located within the cavity defined by the interior walls of the sleeve member to a required depth over the component being protected.

Preferably the sleeve member allows a depth of fluid of at least 3mm to be located in the cavity defined by the sleeve member. In use, the sleeve member can be filled with the fluid to a pre-determined height/depth when located around the component, thereby ensuring accurate and reproducible amounts of fluid around the component.

The fluid can be any required fluid, such as solder, adhesive and/or the like.

In one embodiment the sleeve member has side walls with at least a first and second opening defined therein. The sleeve member is arranged on the PCB so that the edges of the member defining the first opening are adjacent and in contact with the surface of the PCB on which the component to be protected is located.

Preferably the second opening is provided substantially opposite the first opening. The cover means can be provided over the second opening.

The sleeve member, or at least the cross sectional shape of the first opening, is formed of any suitable shape for locating around the component to be protected. For example, the cross sectional dimensions of the sleeve member can be slightly larger than the component about which it is located or can be substantially larger than the component being protected.

Preferably the sleeve member is of such dimensions that a pre-determined space is provided between the component within the sleeve member and interior walls of the sleeve member.

Preferably the one or more components are electronic components for use on a PCB. For example, the component can include a FLASH memory component or a CPU component (central processing unit).

Preferably the sleeve member is provided with engagement means thereon for allowing the sleeve member to be engaged with the PCB. The cover means and/or sleeve member can be provided with engagement means to allow engagement therebetween.

The engagement means in one example includes one or more pins for location in one or more recesses or apertures on a surface of the PCB. The pins typically protrude outwardly of the sleeve member adjacent one or more edges thereof defining the at least first opening.

Preferably the sleeve member is formed from a heat resistant or heat insulating material. The cover means and the sleeve member can be formed from the same material or a different material.

In one example the sleeve member is formed from a plastics material, such as glass filled nylon.

The sleeve member can be integrally formed or can be formed from a plurality of members joined together.

Thus, the protection means of the present invention provides a dam or box like arrangement for a component for limiting the spread of a fluid, such as adhesive, which is to be located around a component, whilst also allowing the correct depth of fluid to be provided around the component. It is a cost effective method which can be undertaken both quickly and easily. Furthermore, the present invention provides increased security against tampering due to the use of a mica cover on the sleeve member.

The cover can be formed partially from mica but in a preferred embodiment the cover is formed substantially entirely from mica. Any suitable mica material can be used.

The PCB can be for use in any item of electrical apparatus, such as for example a broadcast data receiver or set top box.

According to a second aspect of the present invention there is provided protection means for use with a PCB.

According to a further aspect of the present invention there is provided a method of protecting one or more components of a PCB, said method including the steps of locating a sleeve member around at least one component on a PCB, locating a product or fluid in the cavity defined by interior walls of the sleeve member to cover a whole or part of the component and then locating cover means over an opening of said sleeve member, characterised in that the cover means is formed from or includes mica.

An embodiment of the present invention will now be described with reference to the accompanying figures wherein:

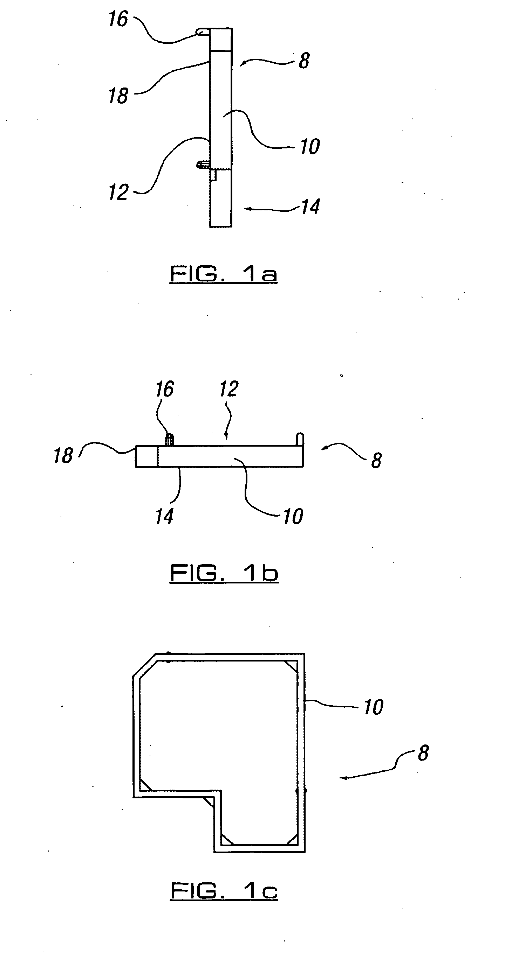

Figures 1a-1c illustrate a side view, end view and plan view respectively of protection means in one example of the present invention;

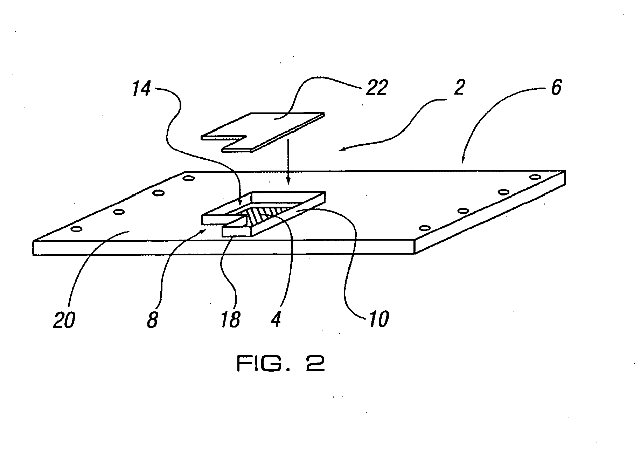

Figure 2 illustrates use of the protection means in figures 1a-1c on a PCB.

Referring to the figures, there is provided protection means 2 for protecting a FLASH memory component 4 of a PCB 6. The PCB can be for use in any suitable item of electrical apparatus.

The protection means 2 includes a sleeve member 8 having side walls 10, a first open end 12 and a second open end 14. Engagement means in the form of a plurality of pins or feet 16 are provided on edge 18 of sleeve member 8 defining first open end 12. The pins 16 protrude outwardly of sleeve member 8 and are located in recesses on a surface 20 of PCB 6 surrounding component 4 in use. With the sleeve member 8 in place on PCB 6, edges 18 defining the first open end 12 are in contact with the surface 20 of PCB 6.

The sleeve member 8 is of a complementary shape to component 4 and is of slightly larger dimensions. Any suitable shaped sleeve member can be used depending on the size and shape of the component or components being protected.

A fluid in the form of an adhesive is then poured into the sleeve member. The adhesive is poured to a pre-determined height in the sleeve member so as to cover component 4 to a pre-determined thickness. The sleeve member acts as a dam to limit or prevent the flow of adhesive beyond the interior cavity defined by the walls of the sleeve member.

Cover means in the form of a cap 22 is then located over second opening 14 to cap the sleeve member, thereby further limiting the flow of adhesive from the sleeve member to any other component on the PCB. Cap 22 also limits or prevents access to the component 4 to protect the same. Cap 22 in this example is in the form of a tile or plate like member which is of substantially complementary shape to the edges of the sleeve member defining the second opening 14. The cap is formed from mica and is of approximately 1mm in thickness. The cap typically has a temperature resistance of greater than 1500 degrees Celsius. As such, it allows dissipation of heat applied to the cap, thereby preventing or limiting access to the cap via third parties. The Mica also has a high dielectric strength and excellent chemical stability, thereby making it a suitable material for use in the present invention.

Component 4, including the pins and the body thereof, needs to be covered by the adhesive to a depth of at least 3mm in this example. The adhesive is ideally required to harden when dry so that the adhesive cannot be peeled off, pierced or removed from the PCB once attached thereto without damaging component 4. The adhesive can be transparent but an opaque adhesive is preferred.

In a preferred embodiment the adhesive needs to be chosen so that the PCB breaks if an attempt to remove the adhesive from the PCB is undertaken. Furthermore, the adhesive typically cures in a time of less than 90 minutes. The exothermic heat generated during curing must be less than the glass transitional temperature of the PCB material, such as FR4 material, in order to prevent bowing or local distortion of the PCB. Thus, in one embodiment the combination of the use of a mica containing cover or cap and use of a hard setting adhesive further increases the security of the protection means of the present invention against third party access to the one or more components being protected by the same.

Preferably the adhesive is an epoxy adhesive, such as DP760 epoxy adhesive supplied by 3M under the trade mark "SCOTCH-WELD". The adhesive typically includes an accelerator component, such as a modified amine.

The protection means therefore substantially isolates the component on the PCB which is to be covered by a fluid or other suitable product and which is to be protected.

## Claims

1. A printed circuit board (6) with protection means (2) for protecting one or more components of the printed circuit board (PCB), said protection means including a sleeve member (8) located on the PCB around at least one component of the PCB, said protection means further including cover means (22) for covering a whole or substantial part of an opening (14) of said sleeve member, **characterised in that** the cover means is formed from or includes mica.

2. A PCB according to claim 1 wherein a product or fluid is located in the sleeve member (8) in use to at least partially cover a component of the PCB (6), walls (10) of the sleeve member preventing spread of the product or fluid externally of the sleeve member.

3. A PCB according to claim 2 wherein the depth of the wall (10) of the sleeve member (8) are such that a product or fluid can be located in the sleeve member to cover the component located within the walls of the sleeve member.

4. A PCB according to claim 3 wherein the depth of the walls (10) of the sleeve member (8) are at least 3 mm.

5. A PCB according to claim 2 wherein the fluid is solder or adhesive.

6. A PCB according to claim 1 wherein the sleeve member (8) has side walls (10) with at least a first opening (12) and a second opening (14) defined therein.

7. A PCB according to claim 6 wherein the first opening (12) is provided substantially opposite to the second opening (14).

8. A PCB according to claim 6 wherein the first opening (12) is provided adjacent to and in contact with a surface (20) of the PCB (6) and the cover means (22) is located on or over the second opening (14).

9. A PCB according to claim 1 wherein the cross sectional shape of the sleeve member (8) is substantially complementary to the shape of a component being surrounded by the sleeve member.

10. A PCB according to claim 1 wherein the sleeve member (8) is of such dimensions that a pre-determined space is defined between the interior walls (10) of the sleeve member and a component located within the sleeve member.

11. A PCB according to claim 1 wherein the one or more components are electrical components.

12. A PCB according to claim 11 wherein the electrical components are a FLASH memory component (4), a central processing unit or processing chip.

13. A PCB according to claim 1 wherein the sleeve member (8) is provided with engagement means for engaging a surface (20) of the PCB (6) and/or the cover means (22).

14. A PCB according to claim 13 wherein the engagement means includes one or more pins (16) for location in one or more recesses or apertures provided on a surface (20) of the PCB (6).

15. A PCB according to claim 13 wherein the engagement means are provided on or adjacent the walls (10) defining the first and/or second openings (12, 14) of the sleeve member (8).

16. A PCB according to claim 1 wherein the sleeve member (8) is formed from heat resistant material.

17. A PCB according to claim 16 wherein the sleeve member (8) is formed from a plastics material.

18. A PCB according to claim 1 wherein the sleeve member (8) is formed from a plurality of wall members (10) joined together.

19. A PCB according to claim 1 wherein the sleeve member (8) is formed from a plurality of integrally formed walls members (10).

20. A PCB according to claim 1 wherein the cover means (22) is in the form of a tile or plate like member.

21. A method of protecting one or more components of a PCB (6), said method including the steps of locating a sleeve member (8) around at least one component on a PCB, locating a product or fluid in the cavity defined by interior walls (10) of the sleeve member to cover a whole or part of the component and then locating cover means (22) over an opening (14) of said sleeve member, **characterised in that** the cover means is formed from or includes mica.

## Patentansprüche

1. Leiterplatte (6) mit einem Schutzmittel (2) zum Schützen von einer oder mehreren Komponenten der Leiterplatte (PCB), wobei das genannte Schutzmittel ein Manschettenelement (8) aufweist, das sich auf der Leiterplatte um wenigstens eine Komponente der Leiterplatte herum befindet, wobei das genannte Schutzmittel ferner ein Abdeckmittel (22) zum Abdecken der gesamten oder eines wesentlichen Teils der Öffnung (14) des genannten Manschettenelementes aufweist, **dadurch gekennzeichnet, dass** das Abdeckmittel aus Glimmer gebildet ist oder Glimmer enthält.

2. Leiterplatte nach Anspruch 1, wobei sich beim Gebrauch im Manschettenelement (8) ein Produkt oder Fluid befindet, um eine Komponente der Leiterplatte (6) wenigstens teilweise abzudecken, wobei Wände (10) des Manschettenelementes eine Verteilung des Produkts oder Fluids außerhalb des Manschettenelementes verhindert.

3. Leiterplatte nach Anspruch 2, wobei die Tiefe der Wände (10) des Manschettenelementes (8) derart ist, dass ein im Manschettenelement befindliches Produkt oder Fluid die innerhalb der Wände des Manschettenelementes befindliche Komponente bedeckt.

4. Leiterplatte nach Anspruch 3, wobei die Tiefe der Wände (10) des Manschettenelementes (8) wenigstens 3 mm beträgt.

5. Leiterplatte nach Anspruch 2, wobei das Fluid Lotmittel oder Klebstoff ist.

6. Leiterplatte nach Anspruch 1, wobei in den Seitenwänden (10) des Manschettenelements (8) wenigstens eine erste Öffnung (12) und eine zweite Öffnung (14) definiert sind.

7. Leiterplatte nach Anspruch 6, wobei die erste Öffnung (12) im Wesentlichen gegenüber der zweiten Öffnung (14) vorgesehen ist.

8. Leiterplatte nach Anspruch 6, wobei die erste Öffnung (12) neben und in Kontakt mit einer Oberfläche (20) der Leiterplatte (6) vorgesehen ist und das Abdeckmittel (22) sich auf oder über der zweiten Öffnung (14) befindet.

9. Leiterplatte nach Anspruch 1, wobei die Querschnittsgestalt des Manschettenelementes (8) im Wesentlichen komplementär zu der Gestalt einer von dem Manschettenelement umgebenen Komponente ist.

10. Leiterplatte nach Anspruch 1, wobei das Manschettenelement (8) derartige Abmessungen hat, dass ein vorbestimmter Raum zwischen den Innenwänden (10) des Manschettenelementes und einer in dem Manschettenelement befindlichen Komponente definiert wird.

11. Leiterplatte nach Anspruch 1, wobei die ein oder mehreren Komponenten elektrische Komponenten sind.

12. Leiterplatte nach Anspruch 11, wobei die elektrischen Komponenten eine FLASH-Memory-Komponente (4), eine Zentraleinheit oder ein Prozessorchip sind.

13. Leiterplatte nach Anspruch 1, wobei das Manschettenelement (8) mit Eingriffsmitteln für den Eingriff in eine Oberfläche (20) der Leiterplatte (6) und/oder das Abdeckmittel (22) vorgesehen ist.

14. Leiterplatte nach Anspruch 13, wobei die Eingriffsmittel ein oder mehrere Stifte (16) beinhalten, die in ein oder mehrere Aussparungen oder Löcher gesteckt werden, die auf einer Oberfläche (20) der Leiterplatte (6) vorgesehen sind.

15. Leiterplatte nach Anspruch 13, wobei die Eingriffsmittel auf oder neben den Wänden (10) vorgesehen sind, die die erste und/oder zweite Öffnung (12, 14) des Manschettenelements (8) definieren.

16. Leiterplatte nach Anspruch 1, wobei das Manschettenelement (8) aus einem wärmebeständigen Material gebildet ist.

17. Leiterplatte nach Anspruch 16, wobei das Manschettenelement (8) aus einem Plastikmaterial gebildet ist.

18. Leiterplatte nach Anspruch 1, wobei das Manschettenelement (8) aus mehreren aneinander gefügten Wandelementen (10) gebildet ist.

19. Leiterplatte nach Anspruch 1, wobei das Manschettenelement (8) aus mehreren einstückig ausgebildeten Wandelementen (10) gebildet ist.

20. Leiterplatte nach Anspruch 1, wobei das Abdeckmittel (22) die Form einer Fliese oder eines plattenähnlichen Elementes hat.

21. Verfahren zum Schützen von ein oder mehreren Komponenten einer Leiterplatte (6), wobei das genannte Verfahren die folgenden Schritte beinhaltet: Positionieren eines Manschettenelementes (8) um wenigstens eine Komponente auf einer Leiterplatte, Geben eines Produkts oder Fluids in den durch Innenwände (10) des Manschettenelementes definierten Hohlraums, um die Komponente ganz oder teilweise abzudecken, und dann Positionieren des Abdeckmittels (22) über einer Öffnung (14) des genannten Manschettenelementes, **dadurch gekennzeichnet, dass** das Abdeckmittel aus Glimmer gebildet ist oder Glimmer enthält.

## Revendications

1. Carte à circuit imprimé (6) dotée de moyens de protection (2) pour protéger un ou plusieurs composants de la carte à circuit imprimé (PCI), lesdits moyens de protection incluant un élément manchon (8) positionné sur la PCI autour d'un composant au moins de la PCI, lesdits moyens de protection incluant en outre des moyens de couverture (22) servant à couvrir la totalité ou une partie sensible d'une ouverture (14) dudit élément manchon, **caractérisée en ce que** les moyens de couverture sont constitués de mica ou incluent du mica.

2. PCI selon la revendication 1, un produit ou un fluide se trouvant dans l'élément manchon (8) afin de couvrir, tout au moins en partie, un composant de la PCI (6), alors que les parois (10) de l'élément manchon empêchent le produit ou le fluide de se propager vers l'extérieur de l'élément manchon.

3. PCI selon la revendication 2, la profondeur des parois (10) de l'élément manchon (8) étant telle qu'un produit ou un fluide peut être placé dans l'élément manchon afin de couvrir le composant positionné à l'intérieur des parois de l'élément manchon.

4. PCI selon la revendication 3, la profondeur des parois (10) de l'élément manchon (8) étant de 3 mm au moins.

5. PCI selon la revendication 2, le fluide étant un métal d'apport de brasage ou un adhésif.

6. PCI selon la revendication 1, l'élément manchon (8) comportant des parois latérales (10) avec au moins une première ouverture (12) et une deuxième ouverture (14) qui y est définie.

7. PCI selon la revendication 6, la première ouverture (12) étant prévue sensiblement en face de la deuxième ouverture (14).

8. PCI selon la revendication 6, la première ouverture (12) étant prévue de façon adjacente à une surface (20) de la PCI (6), et en contact avec cette surface, alors que les moyens de couverture (22) sont positionnés sur la deuxième ouverture (14), ou au-dessus de cette ouverture.

9. PCI selon la revendication 1, la forme en coupe transversale de l'élément manchon (8) étant sensiblement complémentaire de la forme d'un composant lequel est entouré de l'élément manchon.

10. PCI selon la revendication 1, l'élément manchon (8) ayant des dimensions telles qu'un espace prédéterminé est défini entre les parois internes (10) de l'élément manchon et un composant positionné à l'intérieur de l'élément manchon.

11. PCI selon la revendication 1, ledit composant ou plusieurs composants étant des composants électriques.

12. PCI selon la revendication 11, les composants électriques étant un composant mémoire FLASH (4), une unité de traitement centrale ou une puce de traitement.

13. PCI selon la revendication 1, l'élément manchon (8) étant doté de moyens d'engagement destinés à s'engager avec une surface (20) de la PCI (6) et/ou les moyens de couverture (22).

14. PCI selon la revendication 13, les moyens d'engagement incluant une ou plusieurs broches (16) pour être positionnée(s) dans un ou plusieurs évidements ou ouvertures pratiqués sur une surface (20) de la PCI (6).

15. PCI selon la revendication 13, les moyens d'engagement étant prévus sur les parois (10), ou de façon adjacente aux parois, qui définissent la première et/ou la deuxième ouvertures (12, 14) de l'élément manchon (8).

16. PCI selon la revendication 1, l'élément manchon (8) étant fabriqué en un matériau résistant à la chaleur.

17. PCI selon la revendication 16, l'élément manchon (8) étant fabriqué en une matière plastique.

18. PCI selon la revendication 1, l'élément manchon (8) étant constitué d'une pluralité d'éléments parois (10) lesquels sont réunis les uns aux autres.

19. PCI selon la revendication 1, l'élément manchon (8) étant constitué d'une pluralité d'éléments parois (10) formés de façon intégrale.

20. PCI selon la revendication 1, les moyens de couverture (22) se présentant sous la forme d'un élément ressemblant à une dalle ou une plaque.

21. Procédé servant à protéger un ou plusieurs composants d'une PCI (6), ledit procédé incluant les étapes consistant à positionner un élément manchon ( 8) autour d'un composant au moins sur la PCI, à mettre un produit ou un fluide dans la cavité définie par les parois internes (10) de l'élément manchon afin de couvrir la totalité ou une partie du composant et ensuite à positionner les moyens de couverture (22) au-dessus d'une ouverture (14) dudit élément manchon, **caractérisé en ce que** les moyens de couverture sont constitués de mica ou incluent du mica.
